Europäisches Patentamt

European Patent Office

Office européen des brevets

(11) Veröffentlichungsnummer: **0 000 183**

**A1**

## (12) EUROPÄISCHE PATENTANMELDUNG

(21) Anmeldenummer: 78100221.7

(22) Anmeldetag: 22.06.78

(51) Int. Cl.²: **G 03 B 15/00**, G 03 F 1/00

(30) Priorität: 22.06.77 DE 2728086

(43) Veröffentlichungstag der Anmeldung:
10.01.79 Patentblatt 79/1

(84) Benannte Vertragsstaaten:
CH FR GB SE

(71) Anmelder: Platzer, Kurt,
Liebenweiler 19,
D-8991 Achberg (DE)

(72) Erfinder: Platzer, Kurt,
Liebenweiler 19,
D-8991 Achberg (DE)

(74) Vertreter: Kern, Ralf, Dipl.-Ing. et al,
Henkel, Kern, Feiler & Hänzel Patentanwälte
Möhlstrasse 37,
D-8000 München 80 (DE)

(54) Vorrichtung zum Übertragen eines Bilds auf ein licht-empfindliches Aufzeichnungsmaterial.

㊲ Vorrichtung zum Übertragen und wahlweise zum Gestalten eines Bilds auf ein lichtempfindliches Aufzeichnungsmaterial, bei der auf konstruktiv und betriebsmäßig einfache Weise zur Erzielung einer optimalen Gestaltungs- und Verwendungsmöglichkeit eine Einrichtung (4, 26, 21, 19) zur Gestaltung eines Ausgangsbildes mit einem lichtdicht abgeschlossenen photographischen Aufnahmegerät (35) derart kombiniert wird, daß eine manuell leichtgängig bedienbare Abgreifeinrichtung (28) vorgesehen ist, deren Abgreifbewegungen über eine Hebel- und Gestänge-Übertragungsvorrichtung (12) spielfrei durch eine leichtbewegliche Lichtabdichtung (10) in den Innenraum (11a) der Aufnahmekammer (11) übertragbar ist, und daß eine davon unabhängige und außerhalb der Aufnahmekammer angeordnete Lichtquelle (15) mit einer, die Lichtintensität automatisch in Abhängigkeit von der Geschwindigkeit der Abgreifbewegung steuernden Einrichtung vorgesehen ist, deren Lichtsignale über einen Lichtleiter (14) auf einen an der Übertragungsvorrichtung (12) innerhalb der Aufnahmekammer in der Abbildungsebene (D) angebrachten Lichtaustrittskopf (16) übertragbar ist.

FIG.1

**Henkel, Kern, Feiler & Hänzel**

Patentanwälte

Möhlstraße 37
D-8000 München 80

Tel.: 089/982085-87
Telex: 0529802 hnkl d
Telegramme: ellipsoid

- 1 -

<u>Vorrichtung zum Übertragen eines Bilds auf ein licht-
empfindliches Aufzeichnungsmaterial.</u>

Die Erfindung betrifft eine Vorrichtung zum Übertragen und
wahlweise zum Gestalten eines Bilds auf ein lichtempfindliches Aufzeichnungsmaterial.

Bekannte Vorrichtungen ähnlicher Art (z.B. DT-AS 1944 553,
DT-AS 15 47 305, DT-AS 20 43 643 und DT-PS 15 47 305)
bedingen erheblichen apparativen Aufwand und motorischen
Antrieb sowie teilweise aufwendige Programmsteuerung, ohne
daß wirklich eine uneingeschränkte Brauchbarkeit erreicht
wird.

Auch aus DT-OS 20 46 500 und 15 22 468 bekannte Vorrichtungen
erlauben kein mit dem freien oder reproduktiven Zeichnen
oder Malen vergleichbare künstlerisch variable Gestaltungsmöglichkeit, bei welche folgende Voraussetzungen gelten
müssen:

a die beliebige Verwendung von Durchsichts- und Aufsichtsvorlagen mit Projektionsmöglichkeit in verschiedenen,
Maßstäben auf der Vorlagenseite

b eine präzise Kontrolle der Konturen und bestrichenen
Flächen im Bildaufbau wie er (für das Auge unsichtbar)
auf dem lichtsensibilisierten Material während des Arbeitens entsteht

c   die spielfreie Übertragung der Bewegung von eingesetzten Kontrol- und Zeichenstiften auf den Lichtkopf bei gleichzeitiger Leichtgängigkeit (geringste Gewichte und Vermeidung von reibungsbelasteten Hebel-Übersetzungen und spürbaren Behinderungen durch Balgenabdichtungen usw.)

d   ungehindertes Arbeiten bei normaler Tages- und Kunstlichtraumbeleuchtung, ohne das Fotomaterial zu verschleiern

e   uneingeschränkte Wahl des Aufzeichnungsmaterials (z.B. alle bekannten Farb- und Schwarz-weiß Negativ- und Umkehrfilme sowie Positivmaterial einschließlich Sofortbild in praktisch allen marktgängigen Formaten

f   die automatische Anpassung der Lichtintensität an verschiedene Bewegungsgeschwindigkeiten (um den Lichtabdruck kontrollierbar konstant zu halten) ohne Veränderung der spektralen Zusammensetzung des auf das Fotomaterial wirkenden Lichtes (Farbarbeiten!)

g   einfache Lichtmodulation zur Bestimmung der Strichstärke, Grautöne, bzw. Farbwerte sowie Einsatz von Raster- und Verfremdungsmitteln für das Licht, leicht zugänglich außerhalb der Aufnahme-Kammer und Übertragungsapparatur

h   bei der Verwendung von Glasfassersträngen zur Übertragung des Lichtes darf bei geschwindigkeitsabhängiger Lichtsteuerung weder das Farbspektrum (Spannungsänderung) noch die Lichtverteilung im Glasfaserbündelquerschnitt (Lochblendensteuerung und Übertragung über eine veränderbare Auswahl der Anzahl von lichtführenden Glasfasern) verändert werden

i   die gesamte Vorrichtung, einschließlich der Regelung der geschwindigkeitsabhängigen Lichtintensität muß mit relativ einfachen und daher billigen Mitteln realisierbar sein

j die Verwendung allgemein verfügbarer optischer Standardgeräte wie Diaprojektoren und Episkope (zur Vorlagenprojektion) und Aufnahmeapparate, wie Foto- und Filmkameras, Planfilmkassetten mit der Optik eines Vergrößerungskopfes oder einer Balgenkamera sollte möglich sein, um mit vertrauten Apparaturen und Verarbeitungstechniken arbeiten zu können und zugleich einen erheblichen Teil der Investitionskosten zu sparen

k die Vorrichtung soll ohne besondere Ausbildung oder längeres Anlernen bedienbar sein

Aufgabe der Erfindung ist es demgemäß, die Nachteile des Stands der Technik zu vermeiden und mit einfachen Mitteln sowohl die zeichnerische und maltechnische Reproduktion von Vorlagen und die Übertragung derselben in identischer oder abgewandelter Form auf Bildmaterial als auch die bewußte künstlerische Gestaltung in Schwarz-weiß oder Farbe direkt auf lichtsensibilisiertem Material zu ermöglichen.

Demgemäß ist die Erfindung für eine Vorrichtung der eingangs bezeichneten Art gekennzeichnet durch die Kombination einer Einrichtung zur Projektion einer Bildvorlage auf eine Bildebene unter Verwendung eines Projektionsapparates mit einer dieser Einrichtung räumlich fest zugeordneten Aufnahmekammer, in welcher ein photographisches Aufnahmegerät für lichtempfindliches Negativ- oder Positivmaterial angeordnet ist, wobei eine manuell leichtgängig bedienbare Abgreifeinrichtung auf der Bildebene C vorgesehen ist, deren Abgreifbewegungen über eine Hebel- und Gestängeübertragungsvorrichtung spielfrei durch eine leichtbewegliche Lichtabdichtung in den Innenraum der Aufnahmekammer übertragbar ist, und daß eine davon unabhängige und außerhalb der Aufnahmekammer angeordnete Lichtquelle mit einer, die Lichtintensität automatisch in Abhängigkeit von der Geschwindigkeit der Abgreifbewegung steuernden Einrichtung vorgesehen ist, deren Lichtsignale über einen Lichtleiter auf einen an der Übertragungsvorrichtung innerhalb der Aufnahmekammer in der Abbildungsebene angebrachten Lichtaustrittskopf übertragbar sind.

Um eine einwandfreie Handhabung zu gewährleisten, kann die Lichtabdichtung eine leichtgängige, lichtabdichtende Schienenführung sein, in welche ein die Abgreifbewegung übertragender Arm in einer für die Querbewegung (x-Achse) leichtgängig gelagerten Schiene geführt ist, in der ein Durchlaß für die Längsbewegung (y-Achse) des Arms in leichtgängige Lagerung vorgesehen ist, wobei die Schienenführung mit der Schiene horizontalbeweglich angeordnet sind, wobei der Lichtleiter an dem die Abgreifbewegung übertragenden Arm in den Innenraum der Aufnahmekammer geführt sein kann.

Eine noch vereinfachte Ausführungsform der Erfindung besteht darin, daß die Übertragungsvorrichtung in großem Abstand von der Abbildungsebene angeordnet ist und die Abgreifeinrichtung sowie der Lichtaustrittskopf an diesen Abstand überbrückenden Armen, d.h. einem Führungs- und einem Steuerarm, angebracht sind und die Lichtabdichtung ein Balgen ist, der den Steuerarm nahe seinem, dem Lichtaustrittskopf gegenüberliegenden Drehpunkt, lichtdicht umschließt.

Eine für die Erfindung wesentliche Merkmalskombination ist eine die Lichtintensität automatisch in Abhängigkeit von der Geschwindigkeit der Abgreifbewegung steuernde Einrichtung, welche einen oder mehrere Abtastköpfe oder Lichtschranken sowie elektromagnetisch oder abgreifbare Steuersignalelemente aufweist, die ein enges Signalraster besitzen und unmittelbar in Abhängigkeit von der Geschwindigkeit der Abgreifbewegung an den Abtastköpfen vorbei bewegbar sind, sowie eine Einrichtung zur digitalen Auswertung mit logarithmischer Charakteristik der Bewegungsgeschwindigkeit der Steuerstreifen und deren Impulsfolge vorgesehen ist, deren binärer Ausgang mit gestuften Graufilterfahnen bzw. mit einer Lichtsperre versehenen Hubmagnete zum Einschwenken einer Kombination densitometrisch gestufter Graufilterfahnen bzw. der Lichtsperre, die dem jeweiligen Bewegungszustand entspricht, steuerbar ist. Die der Bewegungsgeschwindigkeit entsprechende densitometrische Graufilterkombination, bzw. bei Stillstand die Lichtsperre, werden jeweils gemäß der Auswertung beispielsweise der mit dem Lichtschlitzraster erzeugten Lichtsignale in den Strahlengang geschwenkt.

Erfindungsgemäß wird als Lichtleiter ein flexibles Glasfaserbündel verwandt.

Wesentliche Vorteile der Erfindung liegen in der Verbindung optimal einfacher Konstruktion und Handhabung mit einem maximum freier Bildgestaltungsmöglichkeit und einer vielfältigen Verwendungsmöglichkeit.

Die Erfindung ist nachstehend in mehreren Ausführungsbeispielen anhand von Zeichnungen näher erläutert. Es zeigt:

Fig. 1 eine Seitenansicht der erfindungsgemäßen Vorrichtung teilweise im Schnitt und in teilweise weggebrochener Darstellung (a und b),

Fig. 2 eine Draufsicht auf die Vorrichtung nach Fig. 1 mit teilweise fortgelassenen Einzelteilen,

Fig. 3 eine vergrößerte Querschnitts-Darstellung des starren Lichtleiters der erfindungsgemäßen Vorrichtung im abgedunkelten Raum mit Lichtschiene gemäß Ausschnitt a in Fig. 1,

Fig. 4a eine schematische Seitenansicht einer erfindungsgemäß verwendeten Lichtquelle mit in den Lichtstrahl
einschaltbaren Graufilterfahnen und anderen Lichtmodulationselementen,

Fig. 4b eine Draufsicht auf eine manuell bedienbare Lichtmodulationsmaske mit revolvierbar unterschiedlichen
Elementen,

Fig. 4c eine Draufsicht auf eine mögliche Anordnung der
erfindungsgemäß verwendeten Graufilterfahnen und
deren Betätigungseinrichtung,

Fig. 5 und 6 eine vergrößerte Seitenansicht und eine Ouerschnittsdarstellung der Lichtabdichtung der erfindungsgemäßen Vorrichtung,

Fig. 7 und 8 eine vergrößerte Seiten- und Draufsichtdarstellung des Stiftträgers der erfindungsgemäßen
Vorrichtung,

Fig. 9 bis 11 eine Vorderansicht (Fig. 11) mit beidseitigen
Seitenansichten (Fig. 9 und 11) einer anderen Ausführungsform der Erfindung, sowie

Fig. 12 eine vergrößert dargestellte Draufsicht auf diese
Ausführungsform der Erfindung,

Fig. 13 eine Seitenansicht der mechanischen Ansteuerung der
Impulsbänder mit Abgreifvorrichtung,

Fig. 14 eine Seitenansicht einer weiteren Ausführungsform
der erfindungsgemäßen Vorrichtung, und zwar in vertikaler Anordnung von Bildebene und Abbildungsebene
übereinander mit einfacher direkter Übertragungsvorrichtung

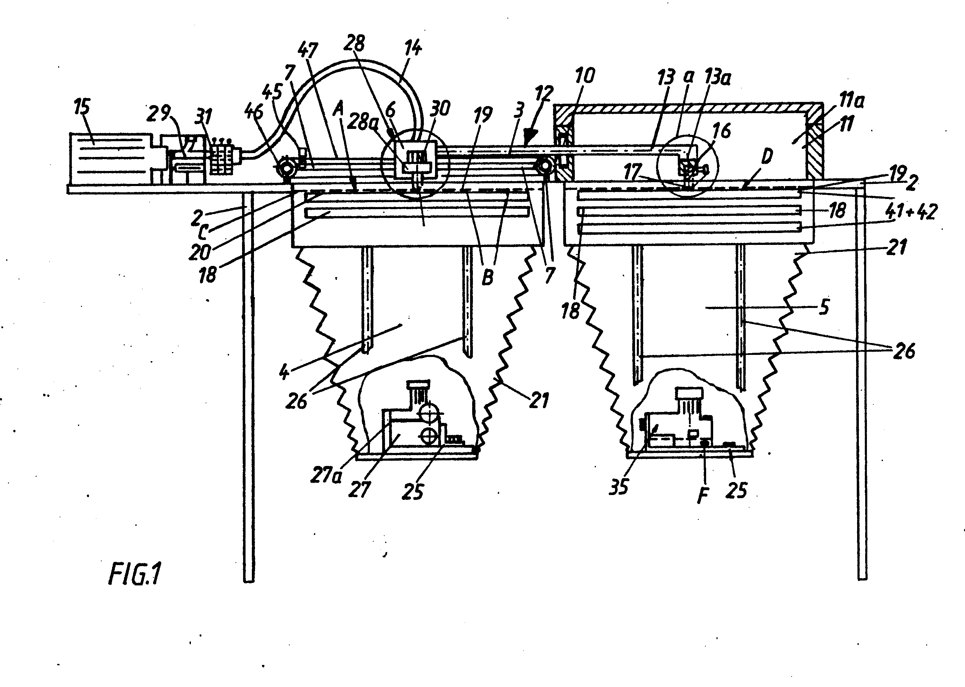

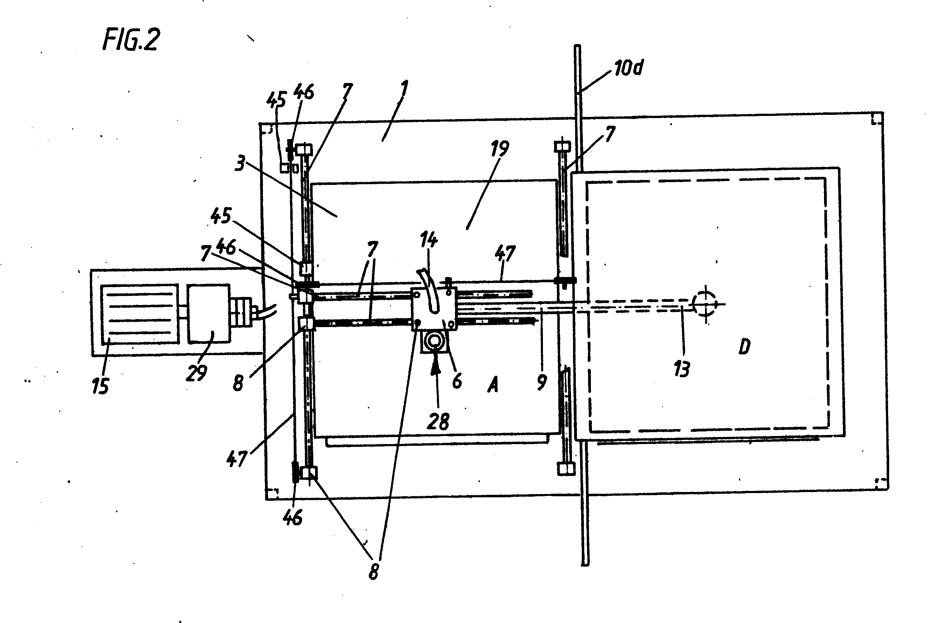

Gemäß Fig. 1 und 2 besitzt die in einem Rahmen 2 gelagerte Vorrichtung auf einer Arbeitsplatte 1 einen Koordinatentisch 3, von dem ein Kontroll-Zeichenpapier bzw. eine Bildvorlage A in einer Bildebene C bestrichen werden kann. Die einzelnen Bildelemente B des Bildes A werden auf dem Koordinatentisch 3 von einer Abgreifeinrichtung 28 mittels eines Stiftträgers 28a koordinatenmäßig aufgezeichnet bzw. bei Benutzung von Vorlagen abgegriffen. Der Stiftträger 28a wird von auf Achsen 7 koordinatenmäßig verschiebbaren Lagerungen 8 im wesentlichen derart gehalten, daß ein im Stiftträger 28a befindlicher Stifteinsatz 28b in der Bildebene C manuell bewegbar ist.

Die Abgreifeinrichtung 28 ist über einen flexiblen Lichtleiter 14, z.B. aus einem Glasfaserbündel mit einer Lichtquelle 15 mechanisch derart verbunden, daß die Bewegbarkeit des Stifteinsatzes 28b über die Fläche des Koordinatentisches nicht beeinträchtigt wird. Die den Lichtleiter 14 beleuchtende Lichtquelle 15 besitzt Vorsätze 31, und zwar z.B. als Lochscheibe mit Graufilterstufung 32, drehbare Scheiben 33 und/oder Filter 34 (z.B. Farb- oder Konversionsfilter) oder sonstige Effektscheiben, z.B. für Trickvorsätze, um das am Lichtleitereingang in den flexiblen Lichtleiter 14 eingegebene Licht in jeder Hinsicht farb-, intensitäts- und effektmäßig modulieren zu können.

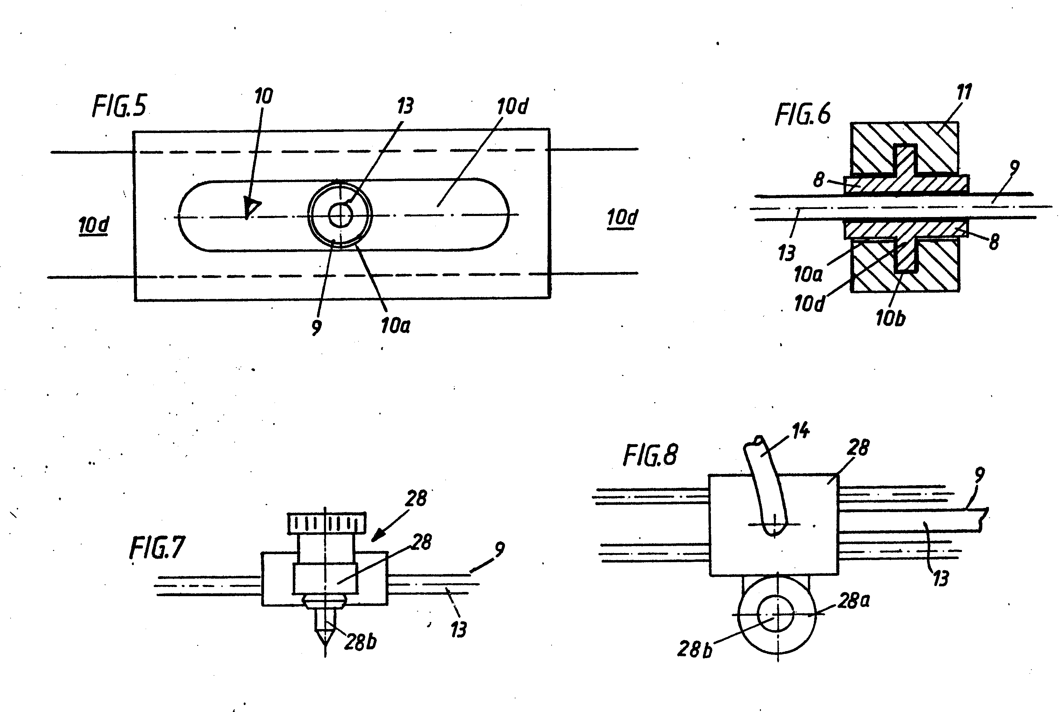

Das von einer Projektionsvorlage 27a mittels eines z.B. herkömmlichen Diaprojektors 27, welcher auf einer zentrierbaren Halterung 25, sowie - zur beliebigen Veränderung des Formats - an vertikalen Führungssäulen 26 innerhalb eines, mit einem Balgen 21 abgedunkelten Vorlagenschachts 4 unterhalb der Bildebene C angeordnet ist - oder horizontal über Umlenkspiegel projiziert - in die Bildebene C, beispielsweise auf eine in einem Rahmen 20 befindliche Mattscheibe 19 projizierte Bild A, kann nun mittels des Stifteinsatzes 28b (Figs. 7 und 8) abgegriffen werden. Die Abgreifbewegung wird mit einer Übertragungsvorrichtung 12, welche mitsamt dem Stiftträger 28a mit ihren Lagerungen 8 auf den Achsen 7 eines Koordinatenschlittens 6 leichtgängig verfahrbar ist, mit einem steifen Arm 9 durch eine Lichtabdichtung 10 hindurch in den Innenraum 11a einer lichtdichten Aufnahmekammer 11 übertragen, in welcher in einem fotographischen Aufnahmegerät 35 ein lichtempfindliches Negativ- oder Positivmaterial F angeordnet ist.

Die Lichtquelle 15 ist mittels des flexiblen Lichtleiters 14 mit der Abgreifeinrichtung 28 verbunden, welcher von dort innerhalb des Arms 9 in die Aufnahmekammer 11 weitergeführt ist, und zwar als steifer Abschnitt 13 bis zu einem mit seinem freien Ende 13a dicht an eine Abbildungsebene D reichenden Lichtaustrittskopf 16.

Zur Erzielung verschiedener Effekte können verschiedene Arten von Stifteinsätzen 28b und entsprechend austauschbare Lichtdüsenvorsätze 17 (z.B. für verschiedene Strichstärken) im Lichtaustrittskopf 16 verwendet werden.

Das in der Abbildungsebene D vom Lichtpunkt des Lichtaustrittskopfes 16 von der Abgreifeinrichtung 28 gezeichnete Bild wird von einem fotographischen Aufnahmegerät 35, beispielsweise einer herkömmlichen Kamera mit offenem Verschluß aufgenommen, welches innerhalb eines von einem Balgen 21 gebildeten Dunkelkammerschachts 5 höhenverstellbar an vertikalen Führungssäulen 26 auf einer zentrierbaren Halterung 25 befestigt ist.

Zur Erzielung verschiedenster Bildveränderungseffekte können sowohl auf der Seite der Bildebene C als auch der Abbildungsebene D Einschübe 18 bzw. 41, 42 für Schablonen, Effektmasken etc. vorgesehen sein, die vorzugsweise auch um 360° in ihrer Ebene drehbar sein können.

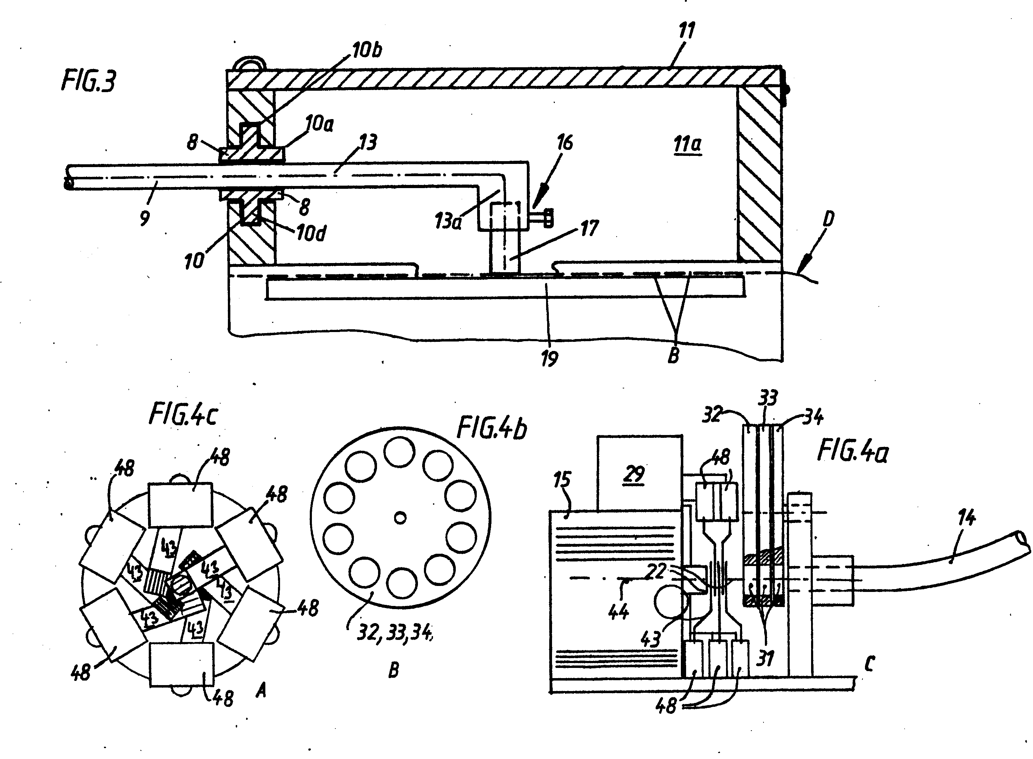

Der notwendige lichtdichte Durchgang des Arms 9 in den Innenraum 11a der Aufnahmekammer 11 wird durch eine (Fig. 3) in einer Nut 10b in Form eines Lichtlabyrinths gelagerte Schiene 10d gewährleistet, während die senkrecht zur Bewegungsbahn der Schiene 10d verlaufende Koordinatenbewegung ebenso leichtgängig durch einen Durchlass 10a erfolgt (Fig. 5 und 6).

Auf diese Weise kann entweder ein in der Bildebene C simultan entstehendes oder von einer Vorlage projiziertes oder sonstwie vorgezeichnetes Bild A aus dem freibeleuchteten Raum in den abgedunkelten Innenraum 11a übertragen werden. Die Konturen des Stifteinsatzes 28b und der Lichtdüsenvorsätze 17 sind aufeinander abgestimmt, so daß in der Bildebene C genau kontrollierbar ist - und zwar einschl. der Strichstärke - welches Bild in die Abbildungsebene übertragen wird.

Um bei unterschiedlich schneller oder langsamer Abgreifbewegung keine unbeabsichtigte Verfälschung des aufgezeichneten Bildes, beispielsweise durch zeitlich bedingte Über- oder Unterbelichtung des Aufnahmematerials zu erhalten, muß die Lichtintensität der Lichtquelle 15 in Abhängigkeit von der Geschwindigkeit der Abgreifbewegung variiert werden. Eine dafür vorgesehene Einrichtung kann mittels jeweils in Koordinatenrichtung über je ein Magnetband oder Lichtrasterstreifen 47 und Rolle 46 verlaufenden Tonabnahmekopf oder Lichtschranke 45, welche entsprechend den Abgreifgeschwindigkeiten der Abgreifeinrichtung 28 eine Signalfolge geben, welche zur Steuerung der Lichtintensität dienen kann und in einer Einrichtung 29 ausgewertet wird.

Für die Steuerung der Lichtintensität sind (Fig. 4a) in den Strahlengang 44 der Lichtquelle 15 mehrere im Dämpfungswert gestufte Graufilterfahnen 43 einschwenkbar, und zwar in verschiedensten Kombinationsmöglichkeiten mittels schnell ansprechender Hubmagnete 48, welche von der Einrichtung 29 zur digitalen Auswertung der Bewegungsgeschwindigkeit der Abgreifeinrichtung gesteuert werden.

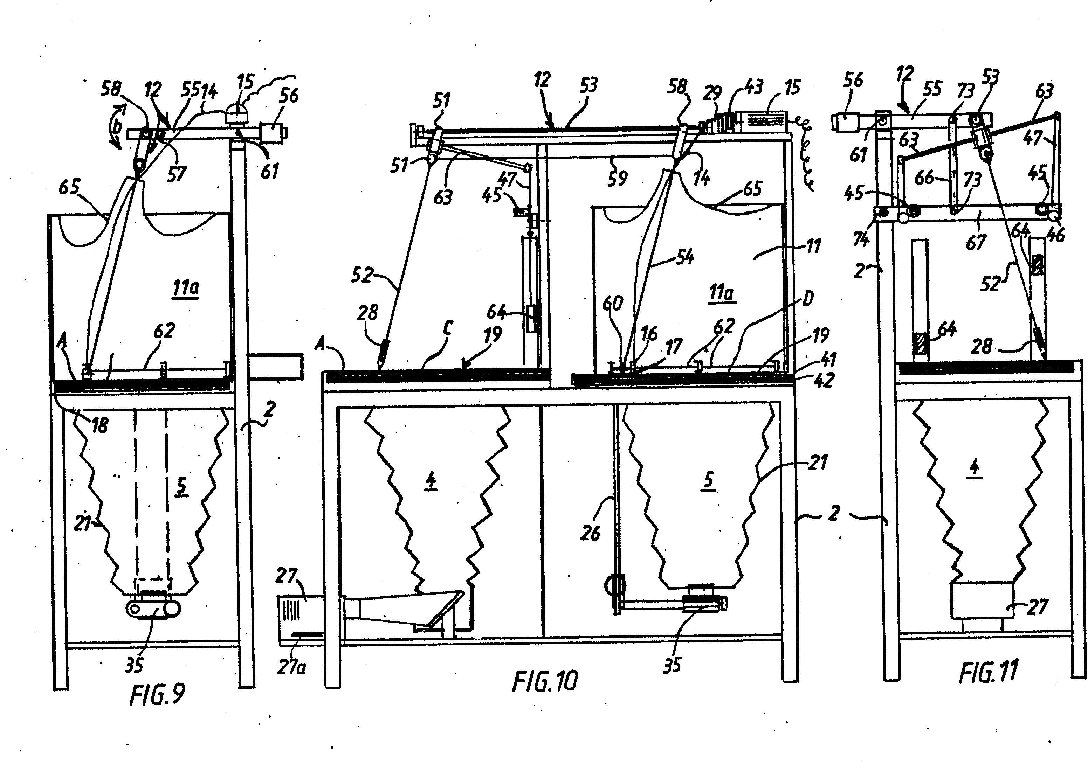

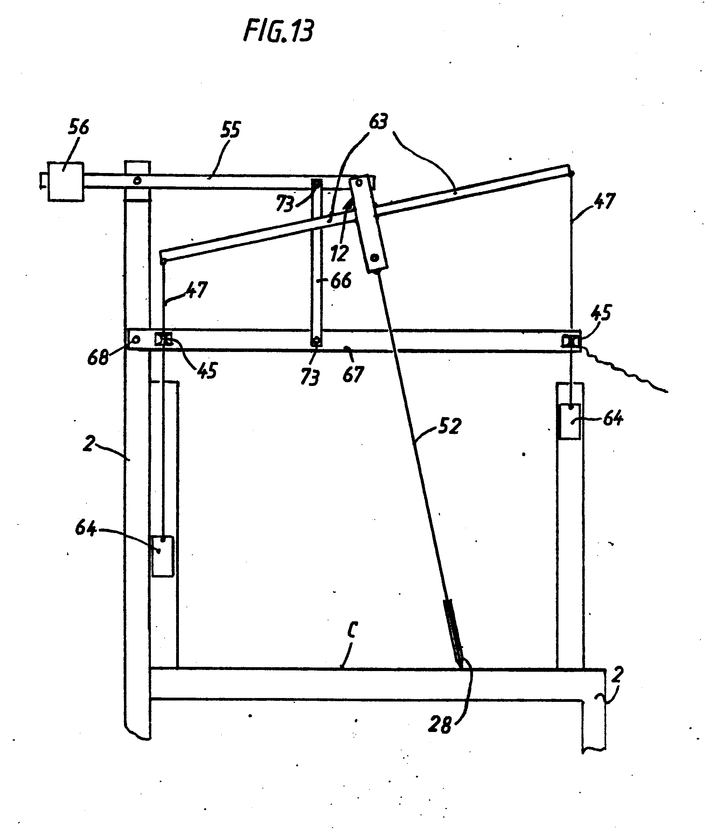

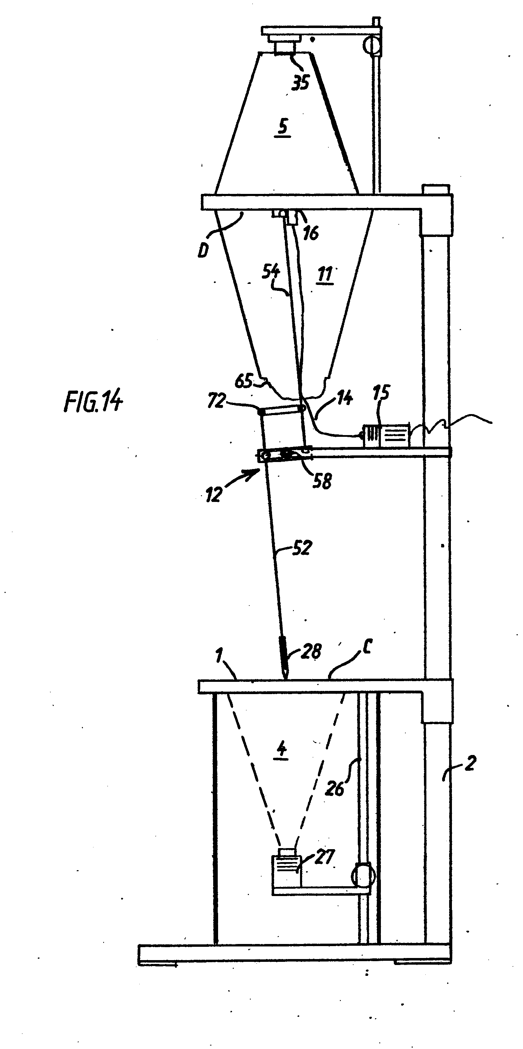

Bei der zu den Figuren 9 bis 14 dargestellten Ausführungsform der Erfindung sind funktionell ähnliche Teile der vorhergehend beschriebenen Ausführungsform mit den gleichen Bezugszeilen versehen.

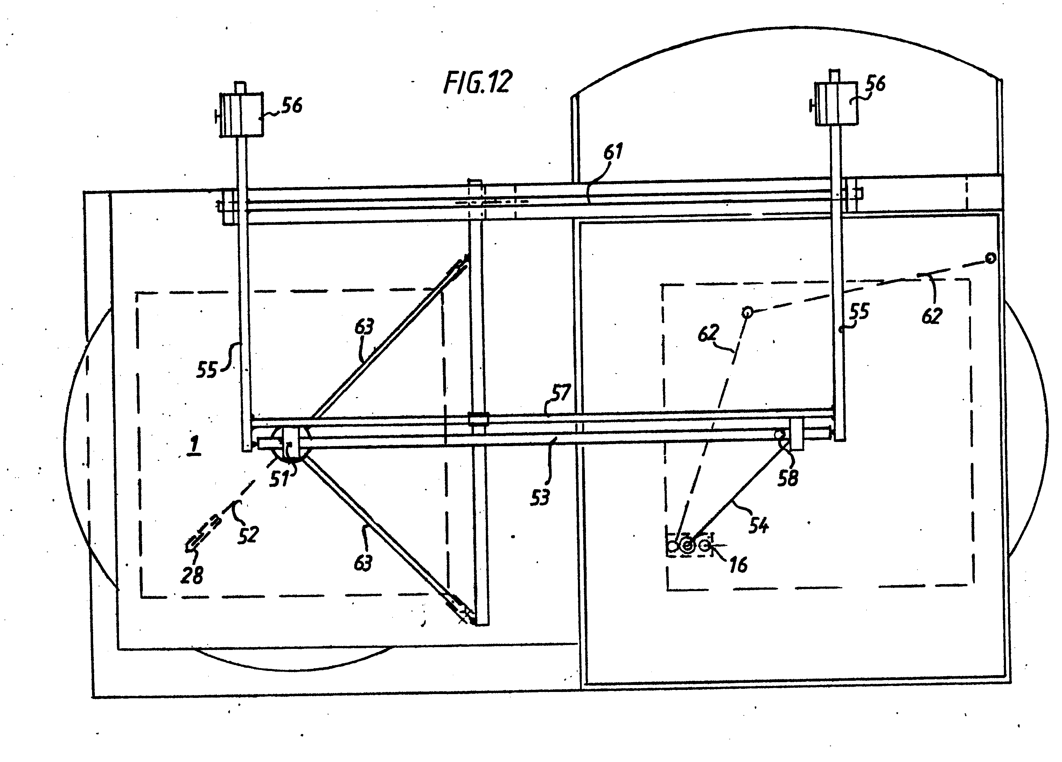

Das z.B. von einem Diaprojektor 27 durch den Vorlagenschacht 4 auf die in der Bildebene C befindliche Mattscheibe 19 - gegebenenfalls über einen Umlenkspiegel - projizierte Bild A der Projektionsvorlage 27a ist von der Abgreifeinrichtung 28 abgreifbar, welche an einem vorzugsweise vergleichsweise langem Führungsarm 52 angebracht ist. Der Führungsarm 52 ist an der Übertragungsvorrichtung 12 angelenkt, und zwar am Drehpunkt 51 einer endseitig frei drehbar gelagerten Welle 53, welche ihrerseits (Fig. 12) auf Schwenkarme 55 mit Gegengewichten 56 leichtgängig ausbalanciert vertikal schwenkbar (gemäß Pfeil b in Fig. 9) ist.

Auf der Seite der Abbildungsebene D ist an der Welle 53 mit einem Drehpunkt 58 ein Steuerarm 54 vorgesehen, an dessen anderem Ende ein Kreuzgelenk 60 zur Führung des Lichtaustrittskopfes 16 auf der Abbildungsebene D angebracht ist, wobei über der Abbildungsebene D schwebend ein Gelenkarm 62 vorgesehen ist, mit welchem das Kreuzgelenk 60 geführt wird.

Ein in etwas Abstand von den Drehpunkten 51 und 58 sowohl an den Führungsarm 52 als auch mit den Steuerarm 54 angelenkter Verbindungsarm 59 bildet mit der Welle 53 ein Paralellogrammgestänge, welches von dem aus den Schwenkarmen 55, der Welle 53 bzw. der Verbindungsstange 57 und der Schwenkwelle 61 für die Schwenkarme 55 vertikal verschwenkbaren Rahmen getragen wird und die Abgreifbewegungen in allen Koordinatenrichtungen überträgt, während die vertikale Verschwenkbarkeit der gesamten Übertragungsvorrichtung um die Schwenkwelle 61 die für Bewegungen der Abgreifeinrichtung 28 in horizontaler Ebene erforderlichen Ausweichbewegungen ermöglicht. Hoch angesetzte Drehpunkte 58 und 51 ergeben zudem eine verbesserte Sichtkontrolle der Bewegungen.

Die Abbildungsebene D liegt tiefer als die Arbeitsplatte 1, damit der Drehpunkt des Kreuzgelenks 60 genau in der Höhe der Vorlagenebene angeordnet ist.

Ein Gelenkarm 62, der in einer Ebene parallel zur Abbildungsebene D bewegbar ist, hält den Lichtaustrittskopf 16 stets senkrecht zur Abbildungsebene D und außerdem zwangsweise in der gleichen Ebene, so daß eine stützende Glasplatte entfallen kann.

Die Lichtabdichtung der Aufnahmekammer 11 besteht aus einem Balgen 65 aus lichtdichtem flexiblen Material, der möglichst nahe am drehpunktseitigen Ende des Steuerarms 54 und vorzugsweise auch gleichzeitig den die Lichtquelle 15 mit dem Lichtaustrittskopf 16 verbindenden flexiblen Lichtleiter 14 lichtdicht umschließt.

Nahe dem Schwenkpunkt 51 sind am Führungsarm 52 seitlich abgewinkelt zwei Hebelarme 63 vorgesehen, welche in einem Winkel von etwa $90^o$ zueinander und etwa $45^o$ zur Basis X- bzw. Z-Achse in der parallel liegenden Arbeitsebene angeordnet sind und an ihrem freien Ende Impulsstreifen (Magnetbänder oder Lichtschlitzraster) zur Erfassung der Geschwindigkeit der Abgreifbewegung tragen, deren Signalwerte zur automatischen Steuerung der Lichtintensität mittels der vor der Lichtquelle 15 kombinierbaren Graufilterfahnen 43 mittels der Einrichtung 29 ausgewertet werden. Die Abtastung der Signalfolge geschieht durch Lichtschranken bzw. induktive Abnahmeköpfe 45.

Die Abnahmeköpfe 45 sind auf einem am Rahmen 2 an einem Schwenkpunkt 68 befestigten Trägerarm 67 angebracht, welcher über einen Verbindungsarm 66 über Drehpunkte 73 mit der vertikalen Schwenkbewegung des Rahmens der Übertragungsvorrichtung 12 verbunden sind. Die Lage der Hebelarme 63 und die schwenkbare Lagerung von zugeordneten Abnahmekopfträgern 67 stellen sicher, daß die Summe der Impulse in allen Bewegungsrichtungen der Strichgeschwindigkeit mm/sec. praktisch proportional ist. Gegenüber bekannten Potentiometerantrieben über X-Y-Achsen vereinfacht sich der arithmetische Steuerteil, da nur mehr die Summe VX + VY gebildet werden muß.

Die Graufilterfahnen 43 zur automatischen Lichtsteuerung erlauben z.B. bei 5 Filtern (Lichtwertdämpfung 1/3, 2/3, 4/3, 8/3, 16/3) insgesamt die Abstufung von 32 Werten bei 1/3 Blendenstufung, wodurch sich ein Steuerbereich von 0-10 Lichtwerten, bzw. das Äquivalent von 10 Blenden ergibt. Die Hinzunahme weiterer Graufilterfahnen dehnt den Bereich über praktisch denkbare Forderungen aus. Wenn der Zeichen- u. Lichtstift in Ruhestellung treten oder sind, wird automatisch eine Lichtsperre ebenfalls in Form einer durch Hubmagnet eingeschwenkten lichtundurchlässigen Fahne in den Strahlengang gebracht. Die Ansprech- und Regelgeschwindigkeit liegt in dem für die Praxis mehr als ausreichenden Bereich von Millisekunden.

Die für sehr langsames Arbeiten bei komplizierten Zeichen- und Malvorgängen erforderliche höchste Auflösung wird z.B. durch die Benutzung von Filmen erreicht, denen ein extrem feiner Schlitzraster aufbelichtet ist. Dieser Raster wird bei der Bewegung des Filmstreifens 47, ausgelöst durch die Zeichenbewegung des Gestänges und übertragen durch die Hebelarme 63, durch die Lichtschranken 45 gezogen und von diesen abgetastet. Wahlweise können anstelle von Magnetbändern oder Lichtrasterstreifen auch Magnetfolien - bzw. Lichtschlitzraster - Scheiben sowie mit Potentiometer arbeitende Elemente verwendet werden, die vorzugsweise an der Peripherie die Impulsmerkmale tragen und zwischen Abnahmeköpfen rotieren. Die Bewegungsübertragung erfolgt über bekannte Seilzüge.

Die beliebige Wahl von als Standardelemente und in stark miniaturisierter Form auf den Markt erhältlichen Hubmagneten 48 wird allen Anforderungen nach schnellsten Schaltzeiten gerecht. Die als elektronischer Geschwindigkeitsumsetzer arbeitende Einrichtung 29 verarbeitet die Verstellgeschwindigkeit jeder X-, bzw. Y-Achse, bzw. die arithmetische Summe aus beiden.

Eine konstruktiv stark vereinfachte Lösung kann mit einer vertikalen Anordnung gemäß Fig. 15 erreicht werden, bei der insbesondere die Übertragungsvorrichtung 12 stark vereinfacht werden kann, wobei allerdings eine größere Bauhöhe inkauf genommen werden muß.

Der Führungsarm 52 der die Bildebene C bestreichenden Abgreifeinrichtung 28 ist dabei über ein Doppelgelenk 72 mit einem gelenkigen Kniehebelarm bewegungsmäßig mit dem Steuerarm 54 verbunden. Der am anderen Ende des Steuerarms 54 vorgesehene Lichtaustrittskopf 16 überträgt dann das abgegriffene Bild von der Bildebene C auf einen in der Abbildungsebene D, angeordneten Aufzeichnungsträger bzw. in ein photographisches Aufzeichnungsgerät 35.

Mit der erfindungsgemäßen Vorrichtung ist es auch möglich stereographische Bilder herzustellen, indem statt eines Standardaufnahmegeräts 35 zwei oder mehrere derartige Geräte in stereographisch relevantem Aufnahmewinkel zur Abbildgsebene C bzw. spezielle Stereoaufnahmegeräte oder -vorsätze angeordnet werden und andererseits die vertikale Schwenkbewegung der Schwenkarme 55 gemäß Fig. 9-13 dahingehend ausgenutzt wird, daß die Abgreifeinrichtung 28 auch in vertikaler Richtung Bewegungen ausführt, welche über die Übertragungsvorrichtung 12 bei fortfallendem Gelenkarm 62 zu entsprechenden Bewegungen des Lichtaustrittskopfes 16 führt, dessen Lichtpunkt dann innerhalb des Innenraumes 11a ein räumliches Bild nachzeichnen. Als Vorlage dient in diesem Falle eine plastische, dreidimensional auf der Bildebene C aufgebaute Vorlage.

## Bezugszeichenliste

A  Kontroll-Zeichenblatt, Bildvorlage

B  Bildelemente (Konturen, Farb-, Tonwertabstufungen)

C  Bildebene

D  Abbildungsebene

F  Negativ- oder Positivmaterial, lichtsensibilisiert


1  Arbeitsplatte

2  Rahmen

3  Koordinatentisch

4  Vorlagenschacht

5  Dunkelkammerschacht

6  Koordinatenschlitten (Kreuzschlitten)

7  Achsen

8  Lagerungen

9  Arm

10  Lichtabdichtung

10a Durchlass

10b Nut, Lichtlabyrinth

10d Schiene

11  Aufnahmekammer

11a Innenraum der Aufnahmekammer

12  Übertragungsvorrichtung

13  Lichtleiter (Glasfaser)

13a freies Ende

14  flexibler Lichtleiter

15  Lichtquelle

16  Lichtaustrittskopf

17  Lichtdüsenvorsätze

18  Einschub

19  Glas-, Mattscheibe

20  Rahmen mit Mattscheibe

21  Balgen

22  Strahlengang

25  zentrierbare Halterung

26  vertikale Führungssäulen

27  Diaprojektor, Episkop

27a Projektionsvorlage

28  Abgreifeinrichtung

28a Stiftträger

28b Stifteinsätze

29  Einrichtung zur digitalen Auswertung

30  Feder

31  Vorsatz mit Blenden, Farb- und Trickscheibe

32  Graufilter-Lochscheibe

33  drehbare Farb-Scheibe

34  drehbare Effektscheibe

35  photograph. Aufnahmegerät

39
41 } Einschübe für Effektmasken, Filter, Schablonen
42

43 Graufilterfahnen

44  Strahlengang

45  Tonabnahmekopf oder Lichtschranke

46  Rolle

47  Magnetband oder Lichtrasterstreifen

48  Hubmagnete

51  Drehpunkt

52  Führungsarm

53  Welle

54  Steuerarm

55  Schwenkarm

56  Gegengewicht

57  Verbindungsstange

58  Drehpunkt

59  Verbindungsarm

0000183

- 17 -

60  Kreuzgelenk
61  Schwenkwelle
62  Gelenkarm
63  Hebelarm
64  Gewichte
65  Balgen
66  Verbindungsarm
67  Trägerarm für Abnahmeköpfe
68  Schwenkpunkt
72  Doppelgelenk
73  Drehpunkt

## Patentansprüche

1. Vorrichtung zum Übertragen und wahlweise zum Gestalten eines Bilds auf ein lichtempfindliches Aufzeichnungsmaterial, gekennzeichnet durch die Kombination einer Einrichtung (4, 26, 21, 19) zur Projektion eine Bildvorlage (A) auf eine Bildebene (C) unter Verwendung eines Projektionsapparates (27) mit einer dieser Einrichtung räumlich fest zugeordneten, lichtdichten Aufnahmekammer (11), in welcher ein photographisches Aufnahmegerät (35) für lichtempfindliches Negativ- oder Positivmaterial (F) angeordnet ist, wobei eine manuell leichtgängig bedienbare Abgreifeinrichtung (28) auf der Bildebene C vorgesehen ist, deren Abgreifbewegungen über eine Hebel- und Gestängeübertragungsvorrichtung (12) spielfrei durch eine leichtbewegliche Lichtabdichtung (10) in den Innenraum (11a) der Aufnahmekammer (11) übertragbar ist, und daß eine davon unabhängige und außerhalb der Aufnahmekammer angeordnete Lichtquelle (15) mit einer, die Lichtintensität automatisch in Abhängigkeit von der Geschwindigkeit der Abgreifbewegung steuernden Einrichtung vorgesehen ist, deren Lichtsignale über einen Lichtleiter (14) auf einen an der Übertragungsvorrichtung (12) innerhalb der Aufnahmekammer in der Abbildungsebene (D) angebrachten Lichtaustrittskopf (16) übertragbar sind.

2. Vorrichtung nach Anspruch 1 dadurch gekennzeichnet, daß die Lichtabdichtung (10) eine leichtgängige, lichtabdichtende Schienenführung ist, in welche ein die Abgreifbewegung übertragender Arm (9) in einer für die Querbewegung (x-Achse) leichtgängig gelagerten Schiene (10d) geführt ist, in der ein Durchlaß (10a) für die Längsbewegung (y-Achse) des Arms in leichtgängiger Lagerung vorgesehen ist, wobei die Schienenführung mit der Schiene (10d) horizontal beweglich angeordnet ist.

3. Vorrichtung nach Anspruch 2 dadurch gekennzeichnet, daß der Lichtleiter (13) in dem die Abgreifbewegung übertragenden Arm (9) in den Innenraum (11a) der Aufnahmekammer (11) geführt ist.

4. Vorrichtung nach Anspruch 1 dadurch gekennzeichnet, daß die Übertragungsvorrichtung (12) in großem Abstand von der Abbildungsebene (D) angeordnet ist, und die Abgreifeinrichtung (28) sowie der Lichtaustrittskopf (16) an diesen Abstand überbrückenden Armen, d.h. einem Führungs- (52) und einem Steuerarm (54), angebracht sind, und die Lichtabdichtung ein Balgen (65) ist, der den Steuerarm nahe seinem, dem Lichtaustrittskopf (16) gegenüberliegenden Drehpunkt (58) lichtdicht umschließt.

5. Vorrichtung nach Anspruch 4 dadurch gekennzeichnet, daß die als Parallelogramm ausgebildete Übertragungsvorrichtung (12) in Schwenkarmen (55) gelagert ist, welche am Ende ihrer Fortsetzung über eine Schwenkwelle (61) verschiebbare Gegengewichte (56) besitzen.

6. Vorrichtung nach einem der vorherigen Ansprüche dadurch gekennzeichnet, daß die Hebelarme (63) für die Übertragung der Bewegungsgeschwindigkeit jeweils in einem Winkel von ca. 45° zur X- und Y-Achse, bei horizontaler parallel zur Abbildungsebene C ausgerichteter Ausgangslage, angeordnet sind.

7. Vorrichtung nach einem der vorherigen Ansprüche dadurch gekennzeichnet, daß der nahe an der Aufhängung des Führungsarmes (52) liegende Schwenkarm (55) einen Verbindungsarm (66) mit jeweils einem Drehpunkt (73) zum Trägerarm (67) für die Lichtschranken oder Abnahmeköpfe aufweist, welcher um einen Schwenkpunkt (68) schwenkbar aufgehängt ist.

8. Vorrichtung nach Anspruch 1 gekennzeichnet durch eine die Lichtintensität automatisch in Abhängigkeit von der Geschwindigkeit der Abgreifbewegung steuernde Einrichtung, welche einen oder mehrere Abtastköpfe sowie elektromagnetisch oder optisch abgreifbaren Steuersignalelemente aufweist, welche ein enges Signalraster besitzen und unmittelbar in Abhängigkeit von der Geschwindigkeit der Abgreifbewegung an den Abtastköpfen vorbei bewegbar sind, sowie eine Einrichtung (29) zur digitalen Auswertung mit logarithmischer Charakteristik der Bewegungsgeschwindigkeit der Steuerstreifen und deren Impulsfolge vorgesehen ist, deren binärer Ausgang mit lichtdämpfungsmäßig gestuften Graufilterfahnen (43) bzw. mit einer Lichtsperre versehenen Hubmagnete (38) zum Einschwenken einer Kombination der Graufilterfahnen bzw. der Lichtsperre in den Strahlengang (22), die dem jeweiligen Bewegungszustand entspricht, steuerbar ist.

9. Vorrichtung nach Anspruch 8 dadurch gekennzeichnet, daß die Abtastköpfe Lichtschranken (45) sind, zwischen denen ein Steuerstreifen (47) mit darauf aufgebrachtem engem Lichtraster bewegbar ist, wobei die Einrichtung (29) die Lichtsignale auswertet.

10. Vorrichtung nach einem der vorherigen Ansprüche dadurch gekennzeichnet, daß die Impulsfolge für die Lichtsteuerung von zwischen oder vor Abnahmeköpfen rotierenden Scheiben abgegeben wird, bei welchen die Impulsanordnung in beliebigem Abstand von der Scheibenmitte im Kreis aufgebracht ist.

11. Vorrichtung nach einem der vorherigen Ansprüche, gekennzeichnet durch Vorsätze (18) für Schablonen, Masken oder ähnliches an der Bildebene (C) und/oder der Abbildungsebene (D), welche um 360° drehbar sind.

0000183

12. Vorrichtung nach einem der vorherigen Ansprüche dadurch gekennzeichnet, daß der Lichtleiter (13) ein flexibles Glasfaserbündel (14) ist.

13. Vorrichtung nach einem der vorherigen Ansprüche dadurch gekennzeichnet, daß die Übertragungsvorrichtung (12) in der Führung des Führungs- (52) und des Steuerarms (54) höhenverstellbar, und die Abgreif- sowie die Abbildungsbewegung mit der Raumkoordinate bewegbar ist, wobei stereomäßig ausgerüstete Aufnahmeapparate in der Aufnahmekammer (11) und dreidimensional abtastbare Modelle als Bildelemente (B) auf der Bildebene (C) vorgesehen sind.

FIG.1

FIG.2

FIG.3

FIG.4c

FIG.4b

FIG.4a

FIG.5

FIG.6

FIG.7

FIG.8

FIG.11

FIG.10

FIG.9

FIG.12

**FIG.13**

FIG.14

| Kategorie | Kennzeichnung des Dokuments mit Angabe, soweit erforderlich, der maßgeblichen Teile | betrifft Anspruch | KLASSIFIKATION DER ANMELDUNG (Int.Cl.²) |
|---|---|---|---|
| **EINSCHLÄGIGE DOKUMENTE** | | | G 03 B 15/00<br>G 03 F 1/00 |
| | US – A – 4 003 061 (P.S.LACANFORA)<br>* Spalte 7, Zeile 47 – Spalte 8, Zeile 30 * | 1,3,12 | |
| | US – A – 1 512 015 (O.BUTZ et al.)<br>* Abbildungen 1-3 * | 1,2 | |
| | DE – C – 345 505 (E.RIEGELMANN)<br>* Abbildung 1 * | 1,4,5 | |
| | DE – A – 1 786 167 (G.CORADI A.G.)<br>* Patentanspruch 1 * | 1,8 | **RECHERCHIERTE SACHGEBIETE (Int. Cl.²)**<br><br>G 03 B 15/00<br>G 03 F 1/00<br>B 43 L 13/02 |
| A | DE – A – 2 217 177 (K.HOPPE)<br>* Gesamt * | 1,3,12 | |
| A | DE – A – 1 957 885 (GRAPHICART)<br>* Gesamt * | 1,4 | |
| DA | DE – A – 2 046 500<br>* Abbildung 1 * | 1,5 | **KATEGORIE DER GENANNTEN DOKUMENTE** |
| A | FR – A – 2 210 763 (SOCIETE NATIONALE INDUSTRIELLE AEROSPATIALE)<br>* Gesamt * | 8,9 | X: von besonderer Bedeutung<br>A: technologischer Hintergrund<br>O: nichtschriftliche Offenbarung<br>P: Zwischenliteratur<br>T: der Erfindung zugrunde liegende Theorien oder Grundsätze |
| A | FR – A – 830 723 (COMPAGNIE FRANCAISE POUR L'EXPLOITATION DES PROCEDES THOMSON HOUSTON)<br>* Abbildung * | 1 | E: kollidierende Anmeldung<br>D: in der Anmeldung angeführtes Dokument<br>L: aus andern Gründen angeführtes Dokument |
| | Der vorliegende Recherchenbericht wurde für alle Patentansprüche erstellt. | | &: Mitglied der gleichen Patentfamilie, übereinstimmendes Dokument |

| Recherchenort | Abschlußdatum der Recherche | Prüfer |
|---|---|---|
| Den Haag | 26-09-1978 | WEYLAND |